(19) Europäisches Patentamt

European Patent Office

Office européen des brevets

(11) EP 0 550 757 B1

(12) **EUROPEAN PATENT SPECIFICATION**

(45) Date of publication and mention
of the grant of the patent:
**10.10.2001 Bulletin 2001/41**

(51) Int Cl.7: **H03K 3/57**, H03K 3/55

(21) Application number: **92908344.2**

(22) Date of filing: **20.04.1992**

(86) International application number:
**PCT/JP92/00503**

(87) International publication number:
**WO 93/00742 (07.01.1993 Gazette 1993/02)**

(54) **PULSE GENERATOR AND DUST COLLECTOR USING SAME**

IMPULSGENERATOR UND STAUBKOLLEKTOR MIT EINEM SOLCHEN IMPULSGENERATOR

GENERATEUR D'IMPULSIONS ET COLLECTEUR DE POUSSIERE L'UTILISANT

(84) Designated Contracting States:
**DE DK SE**

(30) Priority: **28.06.1991 JP 15815891**
**02.07.1991 JP 16134091**

(43) Date of publication of application:
**14.07.1993 Bulletin 1993/28**

(73) Proprietor: **HITACHI METALS, LTD.**
**Chiyoda-ku, Tokyo 100 (JP)**

(72) Inventor: **NAKAJIMA, Shin, 450-3, Niiborishinden**
**Saitama 360 (JP)**

(74) Representative: **Strehl Schübel-Hopf & Partner**
**Maximilianstrasse 54**
**80538 München (DE)**

(56) References cited:
**EP-A- 0 210 298**        **EP-A- 0 417 771**
**JP-A- 2 271 707**        **US-A- 3 786 334**
**US-A- 3 849 670**        **US-A- 4 230 955**

• **JOURNAL OF ELECTROSTATICS, vol.25, no.1, 1**
**June 1990, AMSTERDAM,NL pages 23 - 40 G.**
**DINELLI 'PULSE POWER ELECTROSTATIC**
**TECHNOLOGIES FOR THE CONTROL OF FLUE**
**GAS EMISSIONS'**
• **IEE PROCEEDINGS PART B, vol.137, no.2, 1**
**March 1990, STEVENAGE,UK pages 83 - 88 A.**
**BRAMBILLA ET. AL. 'CIRCUIT ANALYSIS OF A**
**POWER PULSE GENERATOR FOR**
**ELECTROSTATIC PRECIPITATORS'**
• **PATENT ABSTRACTS OF JAPAN vol. 7, no. 149**
**(E-184) (1293) 29 June 1983 & JP-A-58 058 876**
**(MATSUSHITA DENKI K. K.) 7 April 1983**

EP 0 550 757 B1

## Description

Technical Field

The present invention relates to a pulse generating apparatus and a pulsed electrostatic precipitator featuring the said pulse generating apparatus.

Background Art

In the case of reactance load as in a pulsed electrostatic precipitator to efficiently catch high resistivity dust, it is desirable to greatly improve the efficiency of the system by recovering surplus energy supplied again to a load from a pulse generating apparatus at the input side. Such a pulse generating apparatus which can recover surplus energy supplied to a load is known from the pulsed electrostatic precipitator disclosed in the Japanese Patent Publication No. 43062/1982 (KOUKOKU).

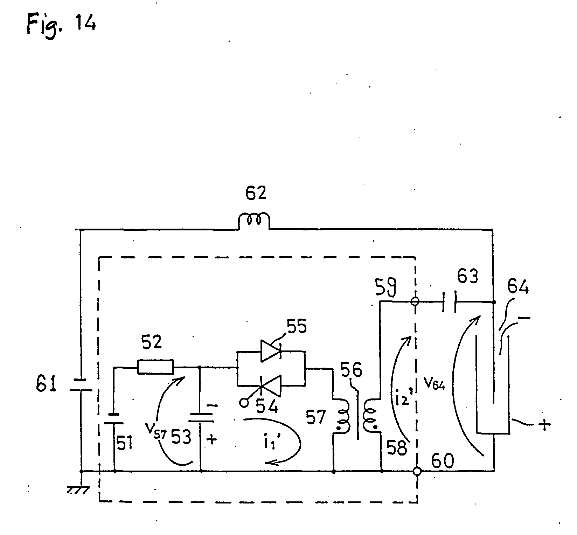

Fig. 14 shows an example of the pulsed electrostatic precipitator disclosed in the Japanese Patent Publication No. 43062/1982 (KOUKOKU) where 51 is the input DC power supply, 52 is the charging resistance of the main capacitor 53, 53 is the main capacitor for input storage energy, 54 is the GTO (Gate Turn-Off Thyristor), or the main switch for discharging the electric charge accumulated in the foregoing main capacitor 53, 55 is a diode, 56 is a step-up transformer, 57 is the primary winding of the step-up transformer 56, 58 is the secondary winding of the step-up transformer 56, 59 and 60 are output terminals of the pulse generator, 61 is the second input DC power supply, 62 is a surge current blocking reactor, 63 is a direct current blocking capacitor and 64 is a precipitation electrode.

In Fig. 14, the DC voltage E61 is continuously supplied to the precipitation electrode in a different direction to V64 along the path from the positive electrode of the input DC power supply 61 to its negative terminal through the precipitation electrode 64 and the surge current blocking reactor 62. In other words, a DC voltage -E61 to the ground is added to the precipitation electrode 64.

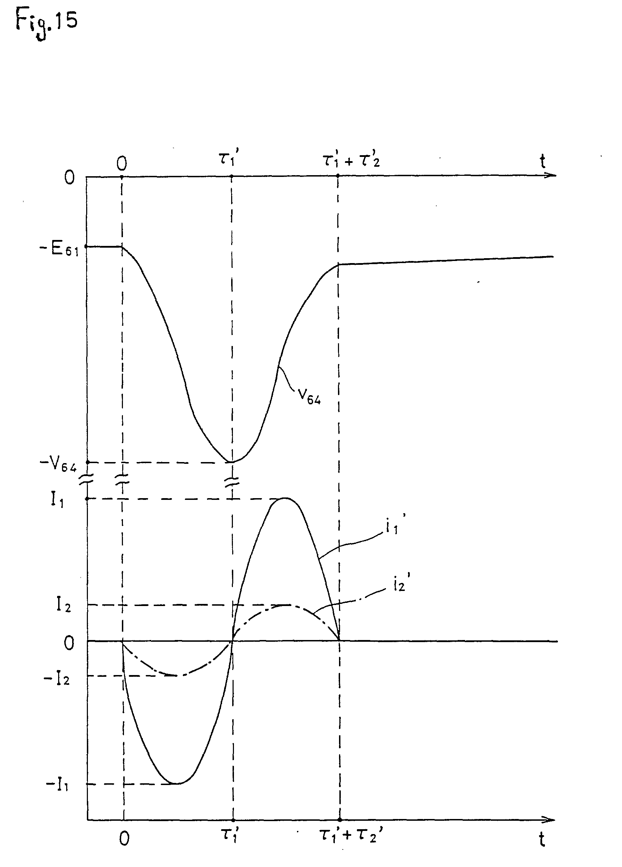

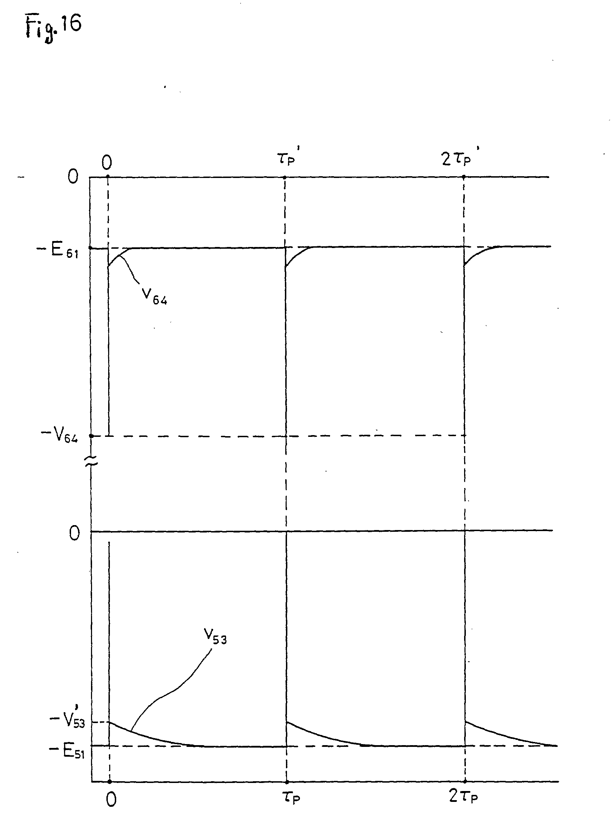

The section inside the broken line in Fig. 14 is the pulse generator, and it has the function of superposing negative high-voltage pulse to the DC voltage -E61 applied to the precipitation electrode 64. The following figures are used to explain its method of operation: Fig. 14 showing its circuit configuration, Fig. 15 showing voltage and current waveforms of major sections in Fig. 14, and Fig. 16 showing the voltage waveforms of major sections in Fig. 14.

To improve the energy transfer efficiency from the main capacitor 53 to the precipitation electrode 64 in the circuit, it is desirable to set the ratio of capacitance between the main capacitor 53, the direct current blocking capacitor 63 and the precipitation electrode 64 to $0.9.N^2 : 10 : 1$ if the turn ratio between the primary winding 57 and the secondary winding 58 of the step-up transformer 56 is set to 1 : N.

When a turn-on signal is input to the gate of GTO 54 and GTO 54 is turned on, the electric charge accumulated in the main capacitor 53 flows in the opposite direction to i1' in Fig. 14, as shown in Fig. 15, along the path from the positive terminal of the main capacitor 53 to its negative terminal through the primary winding 57 of the step-up transformer 56 and GTO 54. As a result, a pulse current conforming to the turn ratio of the step-up transformer 56, like that shown at i2' in Fig. 15, flows in the opposite direction of i2' in Fig. 14 to the secondary winding 58 along the path from the black-dotted terminal of the secondary winding 58 in Fig. 14 to its opposite terminal through the precipitation electrode 64 and the direct current blocking capacitor 63. Due to the pulse current flowing in the opposite direction to i2', a voltage with the peak value V64 is added to the precipitation electrode 64 (the opposite terminal of V64 in Fig. 14). This means that a voltage with the peak value -V64 to the ground like that shown in Fig. 15 is added to the precipitation electrode 64.

The period τ1' from the time the foregoing currents i1' and i2' start flowing to the time they return to zero can be expressed as follows when the leakage inductance from the viewpoint of the primary winding 57 of the step-up transformer 56 is L561 and the total capacitance of the main capacitor 53, the direct current blocking capacitor 63 and the primary winding of the step-up transformer 56 of the precipitation electrode 64 is Ct:

$$\tau1' = \pi \sqrt{L561 \cdot Ct}\,(S) \qquad (1)$$

After τ1' has elapsed from the time GTO 54 is turned on, the electric charge transferred to the precipitation electrode 64 flows in the direction of the current i2' as shown in Fig. 15 along the path from the positive polarity of the precipitation electrode 64 to its negative polarity through the secondary winding 58 of the step-up transformer 56 and the direct current blocking capacitor 63. As a result, a pulse current flows in the same direction as i1' along the path from the black-dotted polarity of the primary winding 57 of the step-up transformer 56 to its opposite polarity through the main capacitor 53 and the diode 55 in Fig. 14, and the electric charge, which is transferred to the foregoing precipitation electrode 64, is returned to the main capacitor 53 to accumulate input energy. The period τ 2' until the pulse current in the same direction as i1' returns to zero is almost equal to τ1' obtained from the foregoing Formula (1).

In the circuit, GTO54 is off from the period τ1' to the period τ1'+τ2' after having been turned on because a turn-off signal is input to its gate. Thus, the electric charge, which is transferred again from the foregoing precipitation electrode 64 to the main capacitor 53 for storing input energy is stored in the main capacitor 53 to recover energy until a turn-on signal is input again to the gate of GTO54 after the period τp' shown in Fig. 16 and GTO54 is turned on. The width of a load, or a pulse voltage, output from the output terminals 59 and 60 of the pulse generator to the precipitation electrode 64 at the time is τ1'+τ2'.

Therefore, the energy, which should be input from the input current power 51 to the main capacitor 53, is only the difference between the DC voltage -E51 of the input DC power supply 51 and storage voltage -V53, thus making it possible to realize a high efficiency pulsed electrostatic precipitator.

In the case of this pulse generating apparatus, however, it is necessary to generate high voltage pulses with large rate of rise of current di/dt, semiconductor switching device like GTO, which is resistant to high voltage, large current and to di/dt, is connected, for the main switch, in series and in parallel as many as it can withstand the high voltage, peak current and di/dt.

For in series/in-parallel connection of semiconductor switching devices, it is necessary to select semiconductor switching devices of comparatively similar characteristics, to strengthen drive circuits, to exert any device for connection between drive circuits and semiconductor switching devices and for wiring between main electrodes of semiconductor switching devices and to insert voltage dividers in order to let such devices equally share voltage and current applied between them in in-series/in-parallel connection.

Thus, the problem occurs that the main switch configuration becomes complicated and large in size. As the number of semiconductor switching devices connected in series and in-parallel increases, there occurs another problem that its drive power increases and its reliability lowers.

In addition, when semiconductor switching devices such as GTO are used for the main switch, the foregoing pulse width τ1'+τ2' is limited to the range of from several tens of μs to 100μs due to restraint by semiconductor device maximum critical rate of di/dt as pointed out in "Performance Improvement of Existing Electrostatic Precipitator by Adding Pulse Energization" by Watabe and Kameshima, Pages 349 to 353 of "Environmental Pollution and Countermeasures" Vol. 25 No.4 (1989).

In order to reduce the foregoing pulse width τ1'+τ2' to below 10μs, studies have been conducted into the use of a highly rate of di/dt mechanical switching device such as rotary gap and a discharge tube switching device like thyratron which are mentioned in Japanese Patent Laid-Open No. 185350/1986 and "Current Technology and Development Activities Concerning Dust Collecting Technique" by Yagyu, Yada, Tsuchiya, Tomimatsu and Matsumoto, Pages 297 to 302 of "Mitsubishi Heavy Industries Technical Report" Vol. 27 No. 4 (1990). When such mechanical switching devices are compared with semiconductor switching devices, problems occurred such as the repetition frequency being limited, the life being extremely short and the reliability low. Also, in the case of discharge tube switching devices such as thyratron, it was found that the repetition frequency could be increased to as high as that of semiconductor switching devices, but problems occurred such as its life being as short and its reliability as low as those of mechanical switching devices as compared with semiconductor switching devices.

Further circuits for generating a short electric current pulse are disclosed in US-3,786,334 and US-4,230,955. These circuits include a semiconductor switch connected in series with a saturable reactor for supplying the current pulse to a load. After the semiconductor switch has been turned on, the reactor, as long as not yet saturated, delays onset of the current pulse and, as soon as it goes into saturation, releases a current pulse with a particularly short rise time.

According to the last-mentioned document, the reactor is provided with a secondary winding for recovering energy from a reverse current originating from minority carriers in the semiconductor switch when the latter is being turned off.

Both these circuits are, however, unsuited for recovering energy from the load itself, e.g. from an electrostatic precipitator.

To recover energy supplied from a storage capacitor via a switch and a saturable reactor to an electrostatic precipitator, EP-A-417 771 proposes to provide the saturable reactor with a secondary winding connected through a rectifier to the storage capacitor. It has been found that this prior art from which the precharacterising portion of claim 1 starts out suffers from a loss of energy and energy cannot be recovered efficiently.

Summary of the Invention

It is an object of the invention to provide a pulse generating apparatus which improves the reliability of the switching device and allows to efficiently recover surplus energy from the load.

This object is solved by the apparatus set forth in claim 1. The subclaims are directed to preferred embodiments of the invention. Claim 6 relates to a pulsed electrostatic precipitator including the pulse generating apparatus of the invention.

In accordance with one embodiment of the present invention, there is a pulse generating apparatus which supplies energy to a load from a series circuit composed of an energy storage capacitor, a main switch for discharging electric charge accumulated in the energy storage capacitor and a saturable reactor, which is provided with a recovery means for recovering energy supplied to the load from a load side end of the saturable reactor to the energy storage capacitor. Another embodiment is a pulse generating apparatus which comprises an energy storage capacitor, a main switch for discharging electric charge stored in the energy storage capacitor and a magnetic pulse compression circuit with saturable reactor and which supplies energy from the energy storage capacitor to a load through the magnetic pulse compression means and which features a recovery means for recovering energy supplied to the load from one end on the load side of the saturable reactor comprised in the magnetic pulse compression circuit to the energy storage capacitor.

A magnetic assist circuit is used for the former embodiment while a magnetic pulse compression circuit is used for the latter embodiment. In the case of the pulse generating apparatus using the magnetic assist circuit, it is possible to delay rise of current between main electrodes of the main switch after the main switch is turned on, thus greatly reducing switching loss and increasing di/dt of the main switch. Therefore, even if a semiconductor switching device is used for the main switch, this new pulse generating apparatus can output pulses not larger than 10μs. In addition, a mechanical switch such as a rotary gap or a discharge tube switching device like thyratron can lengthen its life.

In the case of the pulse generating apparatus featuring a magnetic pulse compression circuit, the magnetic pulse compression circuit is effective to greatly reduce di/dt of the main switch and to output pulses of high di/dt. So, when a semiconductor switch is used as the main switch, the number of in-series/in-parallel semiconductor switching devices can be reduced, and when a mechanical switching device such as a rotary gap or discharge tube switching device like thyratron is used for the main switch, its life can be extended by about two digits.

Since it is equipped with an energy recovery means, the new pulse generating apparatus can greatly improve the efficiency of a system, and a feature of the new apparatus is that the recovery means is located so as to recover energy from one end of the saturable reactor of the load side to the storage capacitor. It would be possible to recover energy through the saturable reactor, but energy could not be recovered efficiently in the experiments of the present inventors due to loss of recovering energy. Thus, according to the invention an energy recovery means is installed which recovers energy from one end of the saturable reactor of the load side to the energy storage capacitor without passing through the saturable reactor, to the new pulse generating apparatus.

A combination of a rectifier and an inductance element like reactor is suitable as the energy recovery means.

Also, the rectifier of the foregoing energy recovery means can be replaced with a series circuit of a rectifying device and a saturable reactor. In this case, it is possible to restrain the reverse recovery current caused by reverse voltage added to the foregoing rectifying device after recovery of energy supplied to the load at the input side, thus reducing the reverse recovery loss of the rectifying device, improving reliability and also decreasing loss of recovery energy as the reverse recovery current flows.

It is possible to provide a pulse generating apparatus which features a transformer at the saturable reactor output side and supplies energy from the energy storage capacitor to the load through the saturable reactor and the transformer.

This transformer makes it possible to output pulses of high peak value with low input voltage and, therefore, to use a switching element of low withstand voltage to discharge electric charge stored in the energy storage capacitor.

Also, in the case of the above pulse generating apparatus, it is possible to provide the saturable reactor with a reset circuit for resetting magnetic flux density of magnetic cores composing the saturable reactor before the main switch is turned on so that the saturable reactor can block voltage pulses during the specified period after the main switch is turned on. Such a reset switch is effective in preventing unstable operation such as time jitter when repeating an operation and also enables the size of the pulse generating apparatus to be reduced because the saturable reactor and operating magnetic flux density can be large.

In the case of a pulsed electrostatic precipitator featuring the above pulse generating apparatus, the simple circuit configuration makes the main switching element operate safely, is effective in generating pulse current of high di/dt and to supply sharp high voltage pulses to the load or the precipitation electrode, and the recovery circuit is effective in recovering most of the energy supplied to the precipitation electrode at the input side. Thus this provides an electrostatic precipitator which is highly reliable, highly efficient and compact.

Brief Description of the Drawings

Fig. 1 is a circuit diagram of the first embodiment of a high voltage pulse generating apparatus in accordance with the present invention.

Fig. 2 is a conceptual diagram of operation magnetizing B-H loop for the saturable reactor 5 in Fig. 1.

Fig. 3 is a diagram showing voltage and current waveforms at major sections in the circuit of Fig. 1.

Fig. 4 is a diagram showing an example of rectifier used for the recovering circuit of a high voltage pulse generating apparatus in accordance with the present invention and the circuit configuration of Rectifier 24 whose reverse recovery characteristics have been improved by connecting saturable reactors 31 in series to the diode 30.

Fig. 5 is a conceptual diagram of operation magnetizing B-H loop for the saturable reactor 31 in Fig. 4.

Fig. 6 is a diagram showing a current i3 of the main winding 32 for the saturable reactor 31 in Fig. 4.

Fig. 7 is a circuit diagram of the second embodiment of the high voltage pulse generating apparatus in accordance with the present invention.

Fig. 8 is a circuit diagram of the third embodiment of the high voltage pulse generating apparatus in accordance with the present invention.

Fig. 9 is a conceptual diagram of the operation magnetizing B-H loop for the saturable reactor 103 in Fig. 8.

Fig. 10 is a diagram showing voltage and current waveforms at major sections in the circuit of Fig. 8.

Fig. 11 is a diagram showing voltage waveforms of the precipitation electrode 17 and the main capacitor 3 in the circuit of Fig. 8.

Fig. 12 is a circuit diagram showing the fourth embodiment of the high voltage pulse generating apparatus in accordance with the present invention.

Fig. 13 is a circuit diagram showing the fifth embodiment of the high voltage pulse generating apparatus in accordance with the present invention.

Fig. 14 is a diagram showing the circuit disclosed in Japanese Patent Publication No. 43067/1982.

Fig. 15 is a diagram showing voltage and current waveforms at major sections in Fig. 14.

Fig. 16 is a diagram showing voltage and current waveforms at major section in Fig. 14.

Detailed Description of the Invention

The embodiments of the present invention are detailed as follows but are not limited to these embodiments only:

(Embodiment 1)

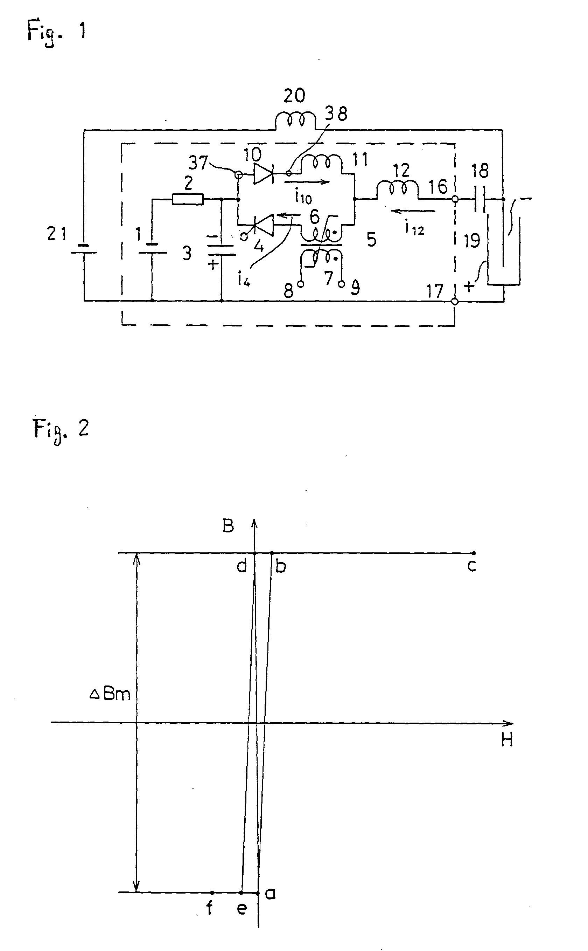

Fig. 1 shows an embodiment of the pulse generating apparatus of the invention and shows an example of a circuit configuration of the pulse generating apparatus to be used for a pulsed electrostatic precipitator. The area within the broken line in Fig. 1 constitutes the pulse generating apparatus, for which a GTO (Gate Turn-off Thyristor) 4, a type of semiconductor switching device, is used as the main switch to discharge electric charge accumulated in the main capacitor 3 for accumulating input energy.

In Fig. 1, 1 is an input DC power supply of the pulse generating apparatus, 2 is a charging resistor of main capacitor 3, 3 is a main energy storage capacitor for storing input energy, 4 is a GTO or a main switch for discharging electric charge stored in the foregoing capacitor 3, 5 is a saturable reactor, 6 is a main winding of the saturable reactor 5, 7 is a reset winding of the saturable reactor 5, 8 and 9 are reset winding terminals of the saturable reactor 5, 10 is a diode, 11 is a reactor, 12 is a reactor to limit di/dt of GTO4, 16 and 17 are output terminals, 18 is a direct current blocking capacitor, 19 is a precipitation electrode, 20 is a surge current blocking reactor and 21 is an input DC power source for applying DC voltage to the precipitation electrode 19.

In the same figure, the DC voltage E is always applied to the indicated polarity of the precipitation electrode 19 in the path from the positive polarity of the input power supply 21 to its negative electrode through the precipitation electrode 19 and the surge current blocking reactor 20.

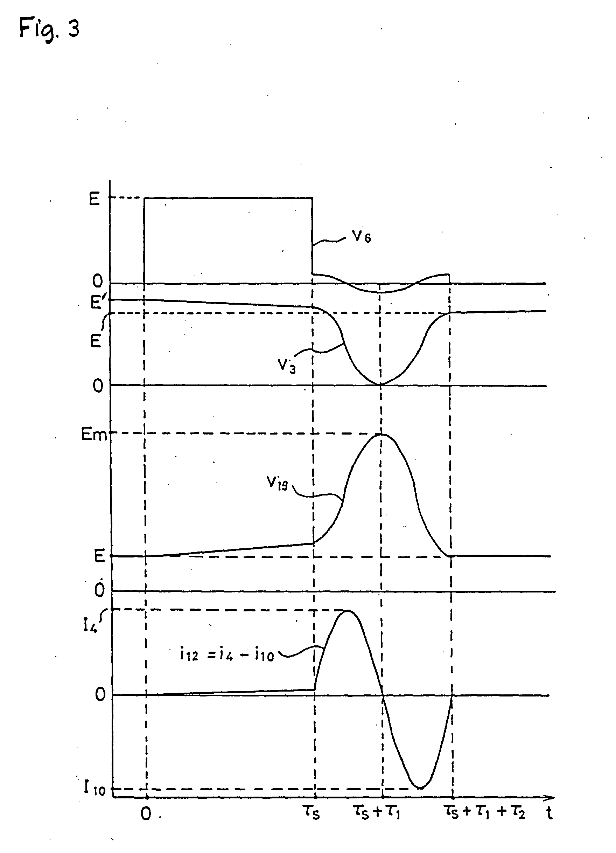

The pulse generating apparatus is used to superpose a high voltage-like pulse to the DC voltage E applied to the precipitation electrode 19, and its operation is explained by using the circuit configuration in Fig. 1 and voltage and current waveforms at major sections in Fig. 2, the conceptual diagram of operation B-H loop of the saturable reactor 6, and Fig. 3.

While GTO4 is off, the main capacitor 3 is charged at its indicated electrode up to the voltage E through the input power supply 1 and the charging resistor 2. At this time, the operating point of the saturable reactor 5 is located at "a" point on the operation B-H loop in Fig. 2.

After a gate current flows to GTO4 and the specified period termed "storage time", depending on the characteristics of GTO, elapses and when the time t in Fig. 3 is 0, the impedance between the main electrodes of GTO4 drops quickly and electric charge stored in the main capacitor 3 starts flowing along the path from the positive electrode of the main capacitor 3 to its negative electrode through the precipitation electrode 19, the direct current blocking capacitor 18, the inductance 12 and the main winding 6 of the saturable reactor 5. As a result, the operating point of the saturable reactor 5 changes from "a" point to "b" point on the operation B-H loop in Fig. 2. Since the inductance of the main winding 6 of the saturable reactor 5 is very high during the period, a very small current i4 comes to flow through the main winding, and, therefore, switching loss can be remarkably reduced when GTO4 is turned on. If the loss can be neglected, the foregoing main winding 6 can block the voltage of the crest value 5 at the black-dotted positive polarity and becomes V6 in Fig. 3.

The period τs during which the main winding 6 of the saturable reactor 5 blocks voltage, is set to a value so that the saturated voltage between the main electrodes becomes sufficiently small after GTO4 is turned on, and has the following relations:

$$\tau s = \frac{N6 \cdot Ae \cdot \Delta Bm}{E} \text{ (S)} \qquad (2)$$

where,

N6 : Number of turns of the main winding 6 of the saturable reactor 5

Ae : Effective cross sectional area (m$^2$) of the saturable reactor 5

ΔBm : Operation magnetic flux density (T) of the saturable reactor 5

E : Input supply voltage (V)

When the operating point of the saturable reactor 5 reaches "b" point on the operation B-H loop, the saturable reactor 5 is saturated, the inductance of the main winding 6 of the saturable reactor 5 drops quickly, and the current i4 running through the main winding 6 turns into a pulse current of very high di/dt identical to the peak value of the waveform i12 in Fig. 3 shown on the positive section as I4. However, since the voltage between the main electrodes of GTO4 has turned into a full low-saturation voltage, the turning-on loss of GTO4 can be fully restrained. So, even if di/dt is increased by several times the value at the time the saturable reactor 5 is actually used, the apparatus can be operated safely. This pulse current changes the operating point of the saturable reactor 5 from "b" point to "d" point through "C" point.

Pulse width $\tau1$ of the pulse current at the time of saturation of saturable reactor 5 can be approximately expressed as follows:

$$\tau1 = \pi \sqrt{C \cdot (L6s + L12)} \qquad (3)$$

where,

C : Combined value (F) of capacities of main capacitor 3, the direct current blocking capacitor 18 and the precipitation electrode 19
L6s : Inductance (H) of main winding 6 of the saturable reactor 5 after saturation
L12 : Inductance (H) of the reactor 12

Since the pulse current flows along the path from the positive terminal of the main capacitor 3 to its negative terminal through the precipitation electrode 19, the direct current blocking capacitor 18, the inductance 12, the main winding 6 of the saturable reactor 5 and GTO4, the high voltage pulse shown by V19 with the crest value Em, can be applied to the precipitation electrode 19.

Since the precipitation electrode 19 is a capacitive load, electric charge input in the precipitation electrode 19 flows along the path from the positive electrode of the precipitation electrode 19, to its negative electrode through the main capacitor 3, the diode 10, the inductances 11 and 12 and the direct current blocking capacitor 18 as a backward pulse current after the time t = $\tau$s + $\tau$1 when the electric charge has been completely shifted to the precipitation electrode 19, so an energy equivalent to the voltage E' can be recovered at the main capacitor 3.

The pulse width $\tau2$ of the pulse current i10 can be expressed as follows:

$$\tau2 = \pi \sqrt{C \cdot (L11 + L12)} \qquad (4)$$

where, L11 : Inductance (H) of reactor 11

During the recovery period, almost no reverse current i4 flows to GTO4 because, when reverse current flows, the operating point of the saturable reactor 5 changes from point "d" to point "e" on the operation B-H loop in Fig. 2, but, at the time the inductance of the main winding 6 of the saturable reactor 5 is much larger than that of the reactor 11 and most of the current flows along the path i10.

Also, if GTO4 has been turned off by discharging the gate current by the time of t=$\tau$s+$\tau$1+$\tau$2 in Fig. 3, it is possible to retain energy recovered at the main capacitor 3 as shown in Fig. 3.

Therefore, energy to be supplied from the input power supply 1 to the main capacitor 3 is only the difference between the foregoing recovered voltage E' and the input supply voltage E.

According to the above operations, it is possible to apply a high voltage pulse with a pulse width of $\tau$1+$\tau$2 obtained from Formulas (3) and (4) to the precipitation electrode 19. The waveform of the voltage applied to the precipitation electrode 19 takes the form V19 in Fig. 3.

To shorten the pulse width $\tau$1+$\tau$2 of the high voltage pulse applied to the precipitation electrode 19, it is more advantageous to shorten $\tau2$ rather than $\tau1$ for the following reasons:

To shorten the pulse width $\tau1$ of the pulse current flowing through the main winding 6 by saturating the saturable reactor 5 while the voltage blocking period $\tau$s of the main winding 6 of the saturable reactor 5 is maintained at a constant value, it is necessary to reduce the inductance L6s after saturation of the main winding 6 of the saturable reactor 5. For that purpose, it is necessary to lengthen the mean magnetic path length le of the saturable reactor 5 because $\tau$s is constant; in other words, the effective cross sectional area Ae of the saturable reactor 5 and number of turns of the main winding 6 are constant. Therefore, to shorten $\tau1$, the size of the saturable reactor should be increased. In addition, shortening the pulse width $\tau1$ would be disadvantageous in that it would increase di/dt of GTO4 and increase the switching loss at the time when GTO is turned on..

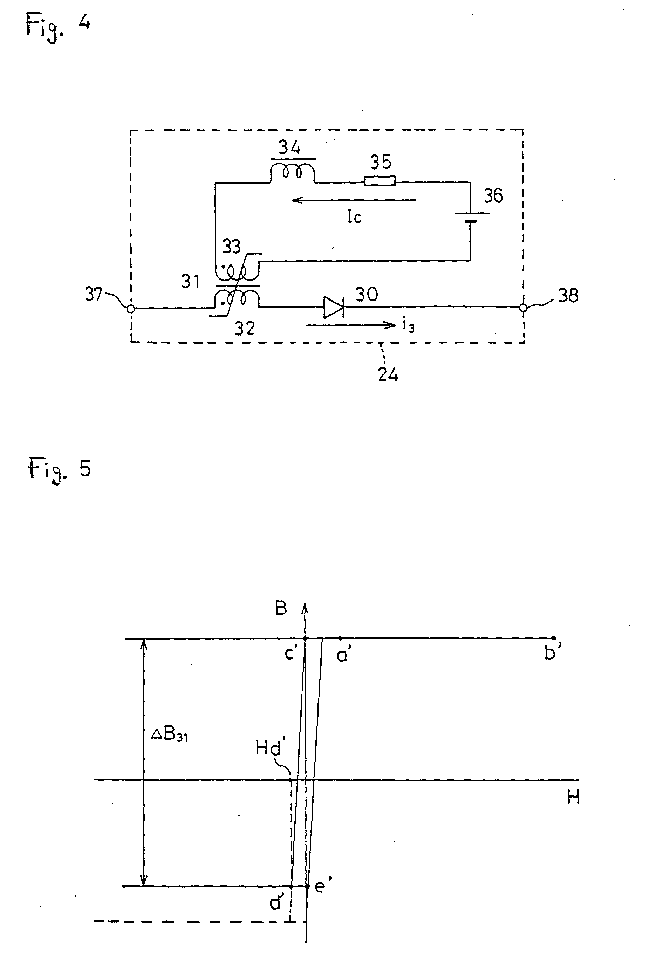

On the other hand, to shorten $\tau2$, it is clear from Formula (4) that the inductance L11 of the reactor 11 must be shortened. For example, this is possible in connection of a simple configuration by omitting reactor 11 between the diode 10 and the reactor 12. Also, when shortening $\tau2$ causes the peak value I10 of the current i10 passing through the diode 10 to increase and the reverse recovery current causes a loss, the loss can be restrained by replacing the diode 10 with the rectifier 24 in Fig. 4 explained later.

During the period from a proper time t=$\tau3$ after GTO4 is turned off to the time it is turned on again, a reset current flows from 8 to 9 of the reset winding end of the saturable reactor 5, so that the operating point of the saturable reactor 5 is set to point "a" again passing through point "f" on the operation B-H loop in Fig. 2.

If a similar operation is repeated, it is possible to generate a small but highly reliable pulse current of high <u>rate of rise current</u> di/dt by using a semiconductor switching device and the recovery circuit greatly increases its efficiency.

Since the voltage E' recovered at the main capacitor 3 is reduced due to the reverse recovery current caused by a reverse voltage applied to the diode 10 after t=τs+τ1+τ2, it is necessary to select a fast reverse recovery diode for diode 10. However, it is difficult to obtain a high withstand voltage diode of fast reverse recovery characteristics, so the reverse recovery characteristics are improved by the diode 10 in Fig. 1 with a rectifier 24 indicated by the broken line in Fig. 4.

In Fig. 4, 31 is a saturable reactor, 32 is a main winding of the saturable reactor 31, 33 is a bias winding of the saturable reactor 31, 34 is a surge current blocking reactor, 35 is a resistor, 36 is a DC power supply, 37 is an anode and 38 is a cathode.

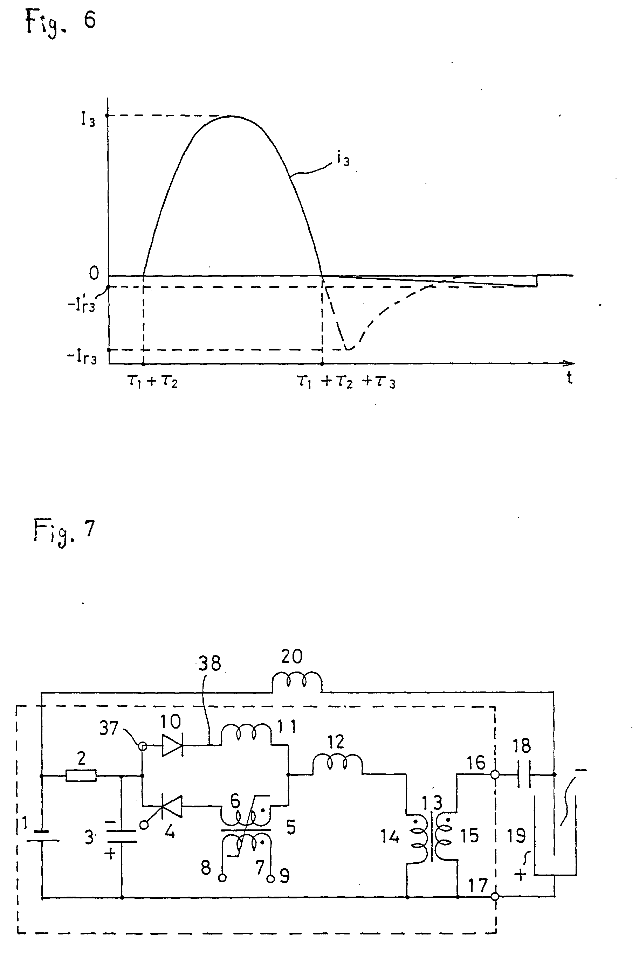

Now, the operation of the rectifier 24 (in Fig. 4) to be used for the diode 10 in Fig. 1 will be explained by using the circuit configuration in Fig. 4, the conceptual diagram of operation B-H loop of the saturable reactor 31 in Fig. 5, the voltage and current waveforms at each section in Fig. 3 and the waveform of the current i3 of the main winding 32 of the saturable reactor 31 in Fig. 6 as follows:

The direct current Ic always flows through the bias winding 33 of the saturable reactor 31, which is magnetized by the direct current to the black-dotted polarity in Fig. 5. Therefore, the operating point of the saturable reactor 31 is located at point "a'" on the operation B-H loop in Fig.5.

When the portion between the anode 37 and the cathode 38 of the rectifier 24 is forward-biased by the time t=τs+τ1, the pulse current i3 having the pulse width τ3 shown in Fig. 6 flows through the main winding 32 of the saturable reactor 31 in the direction shown in Fig. 4 and magnetizes the saturable reactor 31 to the black-dotted polarity. Therefore, the operating point of the saturable reactor 31 moves from point "a'" to point "b'" in Fig. 5, then returns to point "a'" again.

When the time t=τs+τ1+τ2 elapses, the portion between the anode 37 and the cathode 38 of the rectifier 24 is reverse-biased, the electric charge accumulated in the junction capacitance of the diode 30 starts flowing in the opposite direction to i3 in Fig. 4. Therefore, the operating point of the saturable reactor 31 moves from point "a'" to point "d'" through point "c'" in Fig. 5.

When the operating point of the saturable reactor 31 moves from point "a'" to point "d'" through point "c'", the reverse recovery current peak value -Ir3 can be expressed by Formula (5) if the maximum coercive force is Hd' at point "d'" :

$$Ir3 = \frac{Hd' \cdot le'}{N32}(A) \qquad (5)$$

where,

     le' : Mean magnetic path length (m) of the saturable reactor 31
     N32 : Number of turns of the main winding 32 of the saturable reactor 31

If the electric charge accumulated at the foregoing diode 30 is lost, the operating point of the saturable reactor 31 will move from point "d'" to point "e'", then return to point "a'" again due to the magnetizing force of the direct current Ic passing through the foregoing bias winding 33.

As a result, if the rectifier 24 shown in Fig. 4 is used, the reverse recovery current can be better restrained as indicated by the unbroken line in Fig. 6 than in the case where the diode 11 indicated by a broken line in Fig. 6 is used, the reverse recovery loss of the rectifier is greatly decreased, and the reverse recovery current can restrain loss energy recovered in the main capacitor.

As a result, the main switch can be operated safely, the pulse current of high rate of rise current di/dt is generated repeatedly, and the recovery circuit greatly increases its efficiency.

(Embodiment 2)

Fig. 7 presents another embodiment of a high voltage pulse generating apparatus in accordance with the present invention and show an example of circuit configuration of the pulse generating apparatus applied to a pulsed electrostatic precipitator. The broken line contains the pulse generating apparatus. The same numerals are used for identical parts in Embodiment 1.

The basic principle of operation of the pulse generating apparatus in this Embodiment is the same as that for Embodiment 1, but a step-up transformer 13 is provided additionally in order to apply high-voltage pulses of higher peak values than the input DC supply voltage 1. This constitutes the only difference from that in Embodiment 1.

In other words, when the saturable reactor 5 is saturated after GTO4 is turned on, a high voltage pulse of a peak crest value corresponding to the turn ratio of the step-up transformer 13 is superposed, in addition to the voltage of the input DC power supply 1 initially applied to the marked terminal of the precipitation electrode, to the marked terminal by the pulse current flowing from the black-dotted terminal and the reversed polarity side of the primary winding 14 of the foregoing step-up transformer and by the pulse current flowing from the reversed electrode side of the black-dotted terminal of the secondary winding 15 of the transformer 13 to its black-dotted terminal through the precipitation electrode 19 and the direct current blocking capacitor 18. Since the precipitation electrode 19 is a capacitive load, electric charge transferred to the precipitation electrode 19 after it has already been completely charged turns into a reverse pulse current and flows from the positive terminal of the precipitation electrode 19 to its negative terminal through the secondary winding 15 of the step-up transformer 13 and the direct current blocking capacitor 18. Therefore, a pulse current flows along the path from the reversed polarity side of the black-dotted terminal of the primary winding 14 of the step-up transformer 13 to its black-dotted terminal through the main capacitor 3, the diode 10 and the inductances 11 and 12 and generates energy in the main capacitor 3.

When the step-up transformer 13 is not used as in case of the foregoing Embodiment 1, it is necessary to prepare an input DC power supply 21 for the application of DC voltage to the precipitation electrode 19 and another input DC power supply 1 for the pulse generating apparatus and also to enable the latter to supply higher voltage than the former. When a step-up transformer 13 is installed on the pulse generating apparatus, however, the input DC supply voltage for the application of DC voltage to the precipitation electrode 19 and the input DC supply voltage for the pulse generating apparatus may be the same. Therefore, the input DC power supply 1 for the foregoing pulse generating apparatus can also be used as the input DC power supply for the application of DC voltage to the foregoing precipitation electrode 19.

(Embodiment 3)

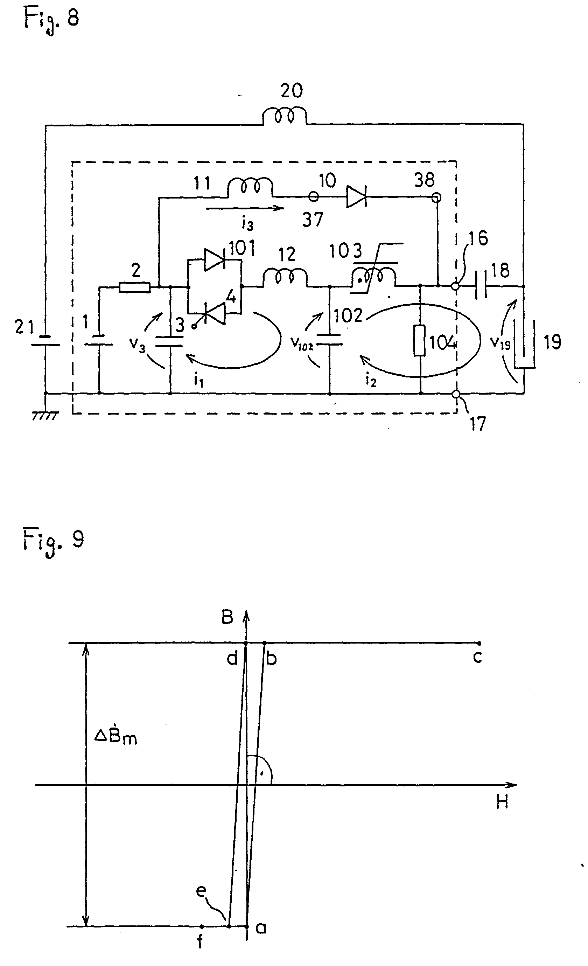

Fig. 8 shows an embodiment of the pulse generating apparatus with magnetic pulse compression circuit in accordance with the present invention and also shows an example of circuit configuration of a pulsed electrostatic precipitator for which GTO, a kind of semiconductor switching device, is used as the main switch for discharging electric charge accumulated in the main capacitor 3 for accumulating input energy.

In Fig. 8, 1 is an input DC power supply, 2 is a charging resistor for main capacitor 3, 3 is the main capacitor for accumulating input energy, 4 is a GTO or a main switch for discharging electric charge accumulated in the foregoing main capacitor 3, 101 is a diode, 12 is a reactor for limiting di/dt of GTO, 102 is a capacitor as a component of a magnetic pulse compression circuit, 103 is a saturable reactor as a component of a magnetic pulse compression circuit, 104 is a resistor, 10 is a diode, 11 is a reactor, 16 and 17 are output terminals of a pulse generator, 21 is the second input DC power supply, 20 is a surge current blocking reactor, 18 is a direct current blocking capacitor and 19 is a precipitation electrode.

In Fig. 8, the DC voltage E21 is always applied to the precipitation electrode 19 in a different direction to V19 along the path from the positive polarity of the input DC power supply 21 to its negative polarity through the precipitation electrode 19 and the surge current blocking reactor 20. This means that the DC voltage -E21 is applied to the precipitation electrode 19 against the ground.

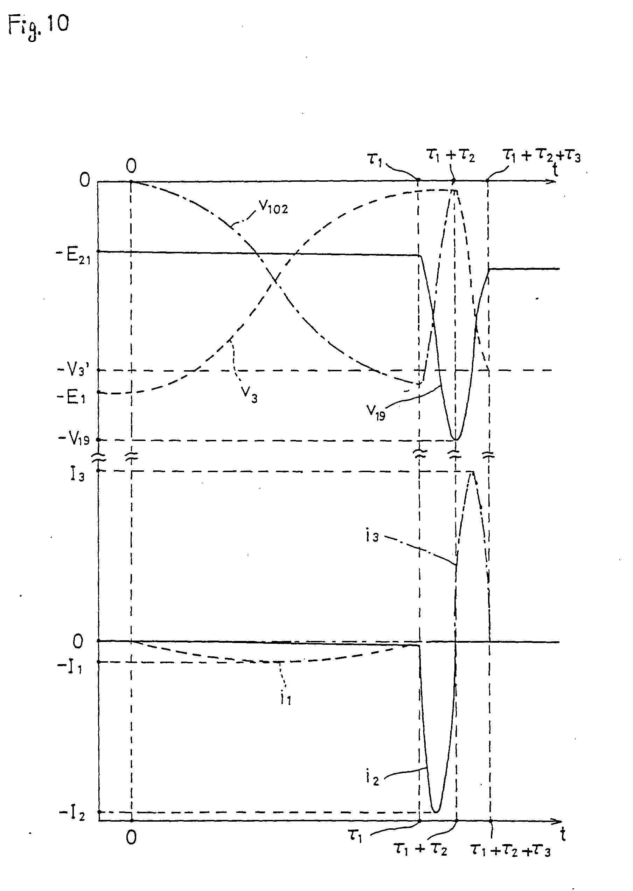

The broken line in Fig. 8 contains the pulse generating apparatus, which has the function of superposing negative polarity high voltage pulse on DC voltage -E21 applied to the precipitation electrode 19. The operation will be explained as follows by using Fig. 8 showing the circuit configuration, Fig. 9 showing the concept of the operation B-H loop of the saturable reactor 103 and Fig. 10 showing voltage and current waveforms of each major section in Fig. 8:

In this embodiment, capacity rates between the main capacitor 3, capacitor 102, direct current blocking capacitor 18 and the precipitation electrode 19 are set to 11:11:120:12 to greatly increase operational efficiency.

While GTO4 is turned off, the main capacitor 3 is charged up to the voltage E1 or up to -E1 against the ground at V3 and the reverse polarity through the charging resistance 2 from the input power supply 1. At this time, the operating point of the saturable reactor 103 is located at point "a" on the operation B-H loop in Fig. 9.

At the time t=0 in Fig. 8 when a gate current flows to GTO4 and a specified period termed "storage time" which depends on the characteristics of GTO elapses, impedance between the main electrodes of GTO4 drops quickly, and due to the current i1 which is indicated by a broken line in Fig. 10 and flows from the GND side of the main capacitor 3 to the opposite side of GND through the capacitor 102, the reactor 12 and GTO4 in the reverse direction to i1 in Fig. 8, electric charge accumulated in the main capacitor 3 moves to the capacitor 102, and the capacitor 102 is charged at the reversed polarity side of the marked V102.

Therefore, the operating point of the saturable reactor 103 moves from point "a" to point "b" on the operation B-H loop in Fig. 9. Since the inductance of the saturable reactor 103 is very high during this period, the current i2 which is indicated by an unbroken line in Fig. 10 and flows to the saturable reactor 103 in the reverse direction to i2 in Fig. 8 becomes very small, and the foregoing saturable reactor 103 blocks almost the same voltage as the voltage V102 of the capacitor 102 shown in Fig. 10. In other words, the foregoing saturable reactor 103 blocks almost the same amount of voltage as the voltage 102 shown in the foregoing Fig. 10 where the black point in Fig. 8 is regarded as the negative polarity. Therefore, the switching loss can be substantially reduced when GTO4 is turned on.

The time τ1 during which the saturable reactor 103 blocks the foregoing voltage V102 is set so that the peak value -I1 and di1/dt of the current i1 flowing through GTO4 are not more than the rated value of GTO4, and τ1 can be approximately expressed as follows:

$$\tau1 = \frac{N103 \cdot Ae \cdot \Delta Bm}{E1} \qquad (6)$$

where,

N103 : Number of turns of the saturable reactor 103
Ae : Effective cross sectional area ($m^2$) of the saturable reactor 103
$\Delta Bm$ : Operation magnetic flux density (T) of the saturable reactor 103
E1 : Input supply voltage (V)

However, to completely transfer the electric charge accumulated in the main capacitor 3 to the capacitor 102, the following formula should be satisfied:

$$\tau1 = \pi \sqrt{C \cdot L12/2} \qquad (7)$$

where,

C : Capacitance (F) of the main capacitor 3
L12 : Inductance (H) of the reactor 12

When the operating point of the saturable reactor 103 reaches point "b" on the operation B-H loop in Fig. 9, the saturable reactor 103 is saturated, the inductance of the saturable reactor 103 drops quickly, and a pulse current of the peak value -I2 and of very high di/dt of the pulse width $\tau2$ like i2 indicated by an unbroken line in Fig. 10 flows through the saturable reactor 103. Also, this pulse current moves the operating point of the saturable reactor 103 from point "b" to point "d" through point "c".

Now, $\tau2$ can be expressed as follows:

$$\tau2 = \pi \sqrt{C \cdot L103 s/2} \qquad (8)$$

where,

C : Capacitance (F) of the capacitor 102
L103s : Inductance (H) of the saturable reactor 103 after saturation

Also, the ratio $\tau1/\tau2$ between the pulse width $\tau1$ of the current i1 and $\tau2$ of the current i2 is termed "compression ratio", and they have the following relations expressed by Formulas (9) and (10):

$$I2/I1 = \tau1/\tau2 \qquad (9)$$

$$di2/dt = (\tau1/\tau2)^2 \cdot (di1/dt) \qquad (10)$$

Therefore, when a magnetic pulse compression circuit with the saturable reactor 103 is used, the pulse of di/dt which is the square of the compression ration $\tau1/\tau2$ can be supplied to the load, or the precipitation electrode, as compared with a electrostatic precipitators without a magnetic pulse compression circuit.
This pulse current i2 flows from the GND side of the capacitor 102 to its opposite side through the precipitation electrode 19, the direct current blocking capacitor 18 and the saturable reactor 103 and can apply a pulse voltage of reverse polarity of V19 in Fig. 8 to the precipitation electrode 19.
The impedance of the resistor 104 is sufficiently as compared with that of the series circuit of the direct current blocking capacitor 18 and the precipitation electrode 19, so the current flowing through the resistance 104 is as small as to be considered negligible as compared with the foregoing pulse current i2.
Since the precipitation electrode 19 is a capacitive load, electric charge input to the precipitation electrode 19 after the time $t=\tau1+\tau2$ elapses when the precipitation electrode 19 is completely charged turns into a pulse current of the pulse width $\tau3$ shown by an alternately long and short dashed line i3 in Fig. 10. The pulse current flows in the reverse direction of the foregoing pulse current i2 along the path from the GND side of the precipitation electrode 19 to its opposite side through the main capacitor 3, the diode 10, the reactor 11 and the direct current blocking capacitor 18. Therefore, an energy equivalent to the voltage -V3' shown in Fig. 10 can be recovered in the main capacitor 3.
$\tau3$ can be expressed as follows:

$$\tau3 = \pi\sqrt{C \cdot L11/2} \qquad (11)$$

where,

C : Capacitance (F) of the capacitor 3
L11 : Inductance (H) of the reactor 11

While the pulse current i3 is flowing, a voltage with straight polarity at the black point in Fig. 8 is applied to the saturable reactor 103, and the operating point of the saturable reactor 103 moves from point "d" to point "e" on the operation B-H loop in Fig. 9. Since the inductance of the saturable reactor 103 is very large at this time, hardly any current flows through the saturable reactor 103.
Also, if GTO4 is turned off by discharging the gate current of GTO4 until the time $t=\tau1+\tau2+\tau3$ shown in Fig. 10 elapses, it is possible to retain recovered energy in the main capacitor 3 as shown in Fig. 10, and energy to be supplied from the input power supply 1 to the main capacitor 3 should be only the difference between the foregoing recovered voltage -V3' and the input supply voltage -E3.
During the period from proper time $t=\tau4$ after

time t=$\tau$1 +$\tau$2+$\tau$3 shown in Fig. 10 elapses, to time t=$\tau$p when GTO4 is turned on again, it is necessary to reset the operating point of the saturable reactor 103 to point "a" again passing through point "e" and point "f" in Fig. 9. The energy necessary for this resetting is mostly obtained from the very small amount energy which could not be recovered from the foregoing precipitation electrode 19 to the main capacitor 3, but, if necessary, a reset circuit to reset it may be provided to the black-dotted point of the saturable reactor 103 in Fig. 8.

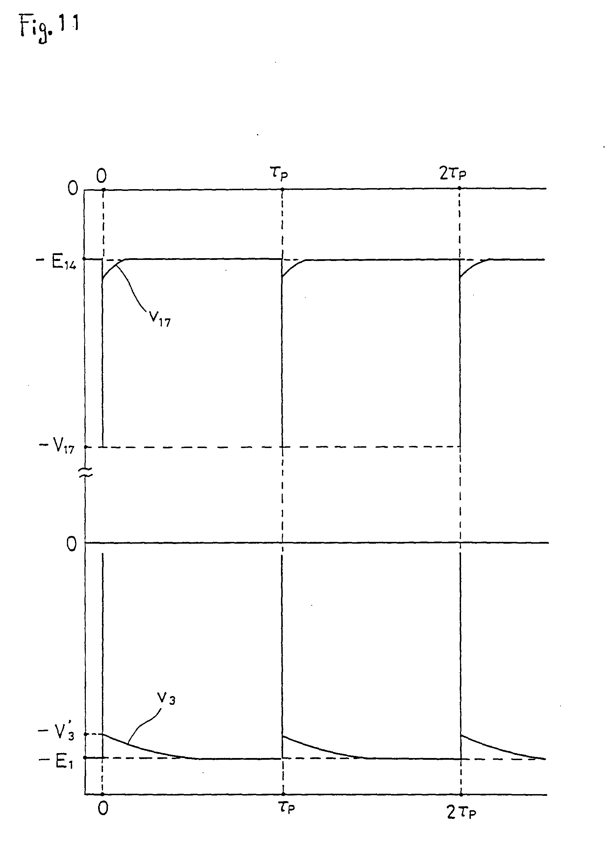

By repeating the same operation, it is possible to apply the voltage shown at V19 in Figs. 10 and 11 on which the pulse voltage of the pulse width $\tau$2+$\tau$3 obtained from the above Formulas (8) and (11)is. Also, the voltage of the main capacitor 3 becomes V3 as shown in Figs. 10 and 11.

The absolute value of the foregoing recovered voltage - V3' of the main capacitor 3 drops due to the reverse recovery current of the diode 10 caused by reverse voltage applied to the diode 10 after the time t=$\tau$1+$\tau$2+$\tau$3 shown in Fig. 10 elapses, so the reverse recovery characteristics can be improved by using the rectifier 24 within the broken line in Fig. 4 for the diode 10 shown in Fig. 8 as in the foregoing Embodiment 1.

As a result, the main switching element can be safely operated, a pulse current of high di/dt can be repeatedly generated, and the recovery circuit can provide highly efficient operation.

(Embodiment 4)

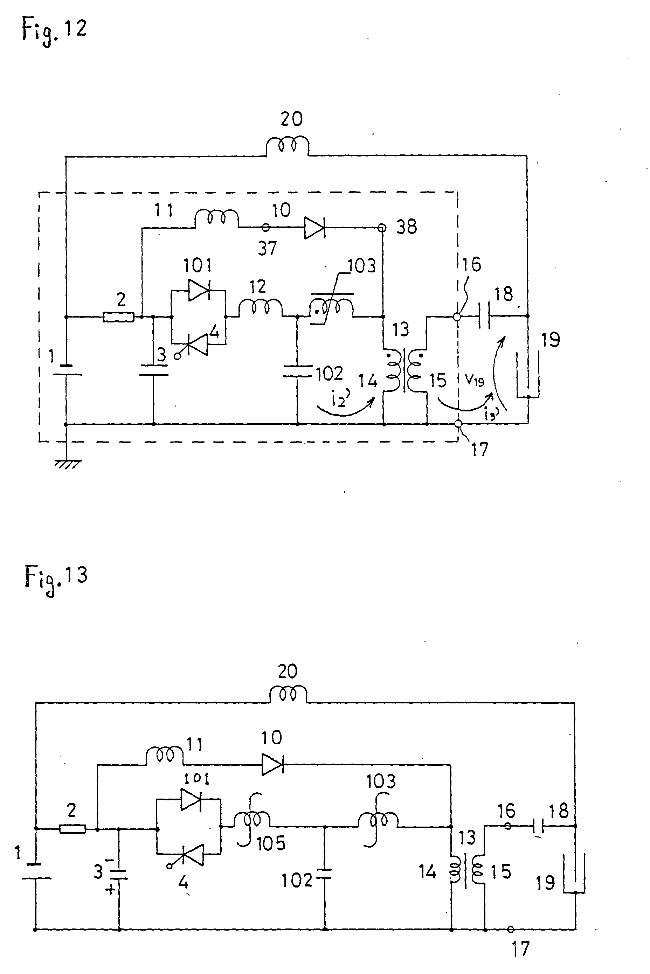

Fig. 12 represents another embodiment of a pulse generating apparatus with magnetic pulse compression circuit in accordance with the present invention and shows an example of the circuit configuration of a pulse generating apparatus used for a pulsed electrostatic precipitator, for which a GTO is used as the main switch for discharging electric charge accumulated in the capacitor 3 for accumulating input energy, and whose purpose is to apply pulse voltage to the precipitation electrode 19 through the step-up transformer 13 equipped on the output side of the magnetic pulse compression circuit. The same numerals are used to indicate the same parts as in Embodiment 3.

In Fig. 12, 1 is an input power supply, 2 is a charging resistance of main capacitor 3, 3 is the main capacitor for accumulating input energy, 4 is a GTO, a main switch for discharging electric charge accumulated in the foregoing main capacitor 3, 101 is a diode, 12 is a reactor for limiting di/dt of GTO4, 102 is a capacitor to provide a magnetic pulse compression circuit, 103 is a saturable reactor to provide a magnetic pulse compression circuit, 13 is a step-up transformer, 14 is a primary winding for the step-up transformer 13, 15 is a secondary winding for the step-up transformer 13, 11 is a diode, 10 is a reactor, 16 and 17 are output terminals of the pulse generating apparatus, 18 is a direct current blocking capacitor, 19 is a precipitation electrode and 20 is a surge current blocking reactor.

In this embodiment, the capacitance ratio between the main capacitor 3, the capacitor 102, the direct current blocking capacitor 18 and the precipitation electrode 19 is set to 175:175:120:12 and the turn ratio between the primary winding 14 and the secondary winding 15 of the step-up transformer 13 is set to 1:4.

In Fig. 12, the DC current E1 is always applied to the precipitation electrode 19 in the reverse direction to V19 in the path from the positive polarity of the input power supply 1 to its negative polarity through the precipitation electrode 19 and the surge current blocking reactor 20. In other words, the DC voltage -E1 is applied to the precipitation electrode 19 against the ground.

The pulse generator is indicated by a broken line in Fig. 12 and is designed to superpose high voltage-like pulse on the DC voltage E1 applied to the precipitation electrode 19, and its basic operation is identical to that in Embodiment 3, with the only difference being that the step-up transformer 13 applies increased pulse voltage to the precipitation electrode 19.

The time $\tau$1 during which the saturable reactor 103 blocks voltage is set so as to satisfy the foregoing Formula (6) in the same way as the Embodiment 3.

To completely transfer electric charge accumulated in the main capacitor 3 to the capacitor 102, it is necessary to satisfy the foregoing Formula (7) in the same way as in Embodiment 3.

The pulse width $\tau$2' of the pulse current i2' which flows through the saturable reactor 103 after the saturable reactor 103 is saturated, can be expressed as follows:

$$\tau2' = \pi\sqrt{\cdot C\ (\ L103s + L131)/2} \qquad (12)$$

where,

C : Capacitance (F) of capacitor 102
L103s : Inductance (H) of the saturable reactor 103 after saturation
L131 : Leakage inductance (H) viewed from the primary winding 14 of the step-up transformer 13

When being input to the primary winding 14 of the step-up transformer 13, the pulse current i2' flows along the path from the reverse polarity side of the black-dotted point at the secondary winding 14 of the step-up transformer 13 to its black-dotted point side through the precipitation electrode 19 and the direct current blocking capacitor 18, and high voltage pulse of peak value corresponding to the turn ratio of the step-up transformer 13 can be applied to the precipitation electrode 19.

Since the precipitation electrode 19 is a capacitive load, electric charge input in the precipitation electrode 19 after the time t=$\tau$1+$\tau$2' elapses during which the precipitation electrode is completely charged, turns into a pulse current and flows along the path from the GND side of the precipitation electrode 10 to the opposite side of GND through the main capacitor 3, the secondary winding 15 of the step-up transformer 13 and the direct current blocking capacitor 18.

Due to this pulse current flowing through the secondary winding 15 of the step-up transformer 13, the pulse current i3' flows along the path from the reverse polarity side of the black-dotted point at the primary winding 14 of the step-up transformer 13 in Fig. 12 to its black-dotted point side through the main capacitor 3, the diode 10 and the reactor 11 and can recover energy in the main capacitor 3.

The pulse width τ3' of the pulse current i3' can be expressed as follows:

$$\tau3\,' = \pi\,\sqrt{C \cdot (L11 + L211)/2} \qquad (13)$$

where,

    C : Capacitance (F) of the capacitor 3
    L11 : Inductance (H) of the reactor 11

At this time, the operating point of the saturable reactor 103 is shifted from point "d" to point "e" on the operation B-H loop shown in Fig. 9 by a voltage applied to the saturable reactor 103 through the step-up transformer 13. Since the inductance of the saturable reactor 103 is very large, hardly any current flows through the saturable reactor 103.

Also, if GTO4 is turned off by discharging the gate current for the time t=τ1+τ2'+τ3', it is possible to retain energy recovered in the main capacitor 3. Therefore, energy to be supplied from the input power supply 1 to the main capacitor 3 should be only the difference between the foregoing recovered voltage and the input supply voltage E1.

For the period from proper time t=τ4 after the time t=τ1 +τ2'+τ3' elapses, to the time t=τp when GTO4 is turned on again, the operating point of the saturable reactor 103 should be reset to point "a" again passing through point "e" and point "f" in Fig. 9. The energy necessary for this resetting is mostly obtained from the very small amount of energy which could not be regenerated from the foregoing precipitation electrode 19 to the main capacitor 3, however, if necessary, a reset circuit may be provided at the black-dotted electrode of the saturable reactor 103 in Fig. 12 during the period from the foregoing time t=τ4 to the time t=τp.

The above operations can superpose a high voltage pulse of the pulse width τ2'+τ3' obtained from Formulas (12) and (13) to the precipitation electrode 19.

Repetition of the above operation causes the main switching element to operate safely and to generate pulse current of high di/dt, and the generation circuit provides highly-efficient operation. In addition, if a step-up transformer is also used, high voltage pulses can be superposed on the precipitation electrode 19 with a low withstand voltage main switch, and even if a semiconductor switching device is used for the main switch, the main switch configuration can be simplified, and its reliability increased.

In this embodiment, explanation has provided on application examples of a pulse generator featuring a one-stage magnetic pulse compression circuit in accordance with the present invention, but in the case of a multi-stage magnetic pulse compression circuit, or in the case of other load having surplus energy supplied, similar effects can surely be obtained.

(Embodiment 5)

Fig. 13 concerns another embodiment of a high voltage pulse generating apparatus with a magnetic pulse compression circuit in accordance with the present invention and shows an example of the circuit configuration of the pulse generating apparatus used for a pulsed electrostatic precipitator by using GTO (Gate Turn-off Thyristor)4, a type of semiconductor switching device as the main switch for discharging electric charge accumulated in the main capacitor for accumulating input energy. The same numerals are used for the same parts as in Embodiment 4.

In Fig. 13, 1 is the input power supply, 2 is the charging resistance of main capacitor 3, 3 is the main capacitor for accumulating input energy, 4 is a GTO, or a main switch for discharging electric charge accumulated in the foregoing capacitor 3, 101 is a diode, 105 is a saturable reactor, 102 is a capacitor for composing a magnetic pulse compression circuit, 103 is a saturable reactor for composing a magnetic pulse compression circuit, 13 is a step-up transformer, 14 is a primary winding of the step-up transformer 13, 15 is a secondary winding of the step-up transformer 13, 16 and 17 are output terminals of the pulse generator, 10 is a diode, 11 is a reactor, 18 is a direct current blocking capacitor, 19 is a precipitation electrode and 20 is a surge current blocking reactor.

The basic operation of this embodiment is the same as that of Embodiment 4, with the only difference being that GTO4, the main switch, is connected to the saturable reactor 105 in series. This in-series connection can reduce switching loss caused when GTO4 is turned on. When a GTO of the same rating is used as in Embodiment 4, it is therefore possible to increase the rate of rise of current di/dt by several times as compared with that in Embodiment 4 and to get output pulses of larger energy.

In this embodiment, explanation has been given on application examples of a pulsed electrostatic precipitator of the invention, but even in the case of other load where impedance between the pulse generator and the load does not match, similar effects can surely be obtained.

## Industrial Applicability

As explained above, this invention makes it possible to recover surplus energy supplied to load in a storage capacitor for accumulating input energy, without needing to pass through a saturable reactor and, therefore, provides a highly efficient pulse generating apparatus.

Especially when the high voltage pulse generating apparatus based on this invention is used for a pulsed electrostatic precipitator, efficiency and reliability, insufficient on conventional apparatuses, can be greatly improved.

## Claims

1. A pulse generating apparatus comprising a series circuit with an energy storage capacitor (3), a main switch (4) and a saturable reactor (5, 103) to supply energy from the energy storage capacitor via the main switch and the saturable reactor to a load (19), and comprising a recovery means (10, 11, 24) for recovering energy supplied to the load and supplying the recovered energy to the energy storage capacitor,
   **characterised in that** the recovery means is connected between the load side of the saturable reactor (5, 103) and the energy storage capacitor (3), thereby by passing the saturable reactor.

2. An apparatus according to claim 1, wherein the recovery means comprises a rectifier (10, 24) and an inductance element (11).

3. An apparatus according to claim 2, wherein the rectifier (24) comprises a rectifying element (30) and a further saturable reactor (31) connected in series for limiting the reverse recovery current of the rectifying element.

4. An apparatus according to any of claims 1 to 3, wherein said series circuit includes a transformer (13) at the load side of the saturable reactor (5) to supply the energy from the storage capacitor (3) to the load (19) through the transformer.

5. An apparatus according to any of claims 1 to 4, comprising a magnetic pulse compression circuit having said saturable reactor (103) and a capacitor (102) for intermediate storage of electric charge from the energy storage capacitor (3).

6. A pulsed electrostatic precipitator including a pulse generating apparatus according to any of claims 1 to 5 and a precipitation electrode (19) as said load.

## Patentansprüche

1. Impulserzeugende Vorrichtung, die eine Serienschaltung mit einem Energiespeicher-Kondensator (3), einem Hauptschalter (4) und einer sättigbaren Drossel (5, 103), um Energie von dem Energiespeicher-Kondensator über den Hauptschalter und die sättigbare Drossel an eine Last (19) zu liefern, und eine Rückgewinnungseinrichtung (10, 11, 24) zum Rückgewinnen von an die Last gelieferter Energie und zum Liefern der rückgewonnenen Energie an den Energiespeicher-Kondensator aufweist,
   **dadurch gekennzeichnet, daß** die Rückgewinnungseinrichtung zwischen die Lastseite der sättigbaren Drossel (5, 103) und den Energiespeicher-Kondensator (3) geschaltet ist, um die sättigbare Drossel zu überbrücken.

2. Vorrichtung nach Anspruch 1, wobei die Rückgewinnungseinrichtung einen Gleichrichter (10, 24) und ein Induktivitätselement (11) aufweist.

3. Vorrichtung nach Anspruch 2, wobei der Gleichrichter (24) in Serie geschaltet ein Gleichrichtelement (30) und eine weitere sättigbare Drossel (31) aufweist, um den Rückgewinnungs-Rückwärtsstrom des Gleichrichtelements zu begrenzen.

4. Vorrichtung nach einem der Ansprüche 1 bis 3, wobei die Serienschaltung auf der Lastseite der sättigbaren Drossel (5) einen Transformator (13) aufweist, um durch ihn die Energie von dem Speicher-Kondensator an die Last (19) zu liefern.

5. Vorrichtung nach einem der Ansprüche 1 bis 4, mit einer magnetischen Impuls-Verkürzungsschaltung, die die genannte sättigbare Drossel (103) und einen Kondensator (102) zum Zwischenspeichern elektrischer Ladung von dem Energiespeicher-Kondensator (3) beinhaltet.

6. Gepulster elektrostatischer Abscheider mit einer impulserzeugenden Vorrichtung nach einem der Ansprüche 1 bis 5 und einer Niederschlagselektrode (19) für die genannte Last.

## Revendications

1. Dispositif de production d'impulsions comprenant un circuit en série ayant un condensateur de stockage d'énergie (3), un commutateur principal (4) et un composant réactif pouvant être saturé (5, 103) pour fournir de l'énergie en provenance du condensateur de stockage d'énergie par l'intermédiaire du commutateur principal et du composant réactif pouvant être saturé à une charge (19), et comprenant des moyens de récupération (10, 11, 24) pour récupérer l'énergie fournie à la charge et pour fournir l'énergie récupérée au condensateur de stockage d'énergie,

   **caractérisé en ce que** les moyens de récupération sont reliés entre le côté charge du composant réactif pouvant être saturé (5, 103) et le condensateur de stockage d'énergie (3), contournant de ce fait le composant réactif pouvant être saturé.

**2.** Dispositif selon la revendication 1, dans lequel les moyens de récupération comprennent un redresseur (10, 24) et un élément d'inductance (11).

**3.** Dispositif selon la revendication 2, dans lequel le redresseur (24) comprend un élément de redressement (30) et un composant réactif pouvant être saturé supplémentaire (31) reliés en série pour limiter le courant de récupération inverse de l'élément de redressement.

**4.** Dispositif selon l'une quelconque des revendications 1 à 3, dans lequel ledit circuit en série comprend un transformateur (13) au niveau du côté charge du composant réactif pouvant être saturé (5) pour fournir l'énergie, en provenance du condensateur de stockage (3), à la charge (19) par l'intermédiaire du transformateur.

**5.** Dispositif selon l'une quelconque des revendications 1 à 4, comprenant un circuit de compression d'impulsions magnétiques ayant ledit composant réactif pouvant être saturé (103) et un condensateur (102) pour un stockage intermédiaire d'une charge électrique en provenance du condensateur de stockage d'énergie (3).

**6.** Dispositif de précipitation électrostatique à impulsions comprenant un dispositif de production d'impulsions selon l'une quelconque des revendications 1 à 5 et une électrode de précipitation (19) en tant que dite charge.

**Fig. 1**

**Fig. 2**

Fig. 3

Fig. 4

Fig. 5

Fig. 6

Fig. 7

Fig. 8

Fig. 9

Fig. 10

Fig. 11

Fig. 12

Fig. 13

Fig. 14

Fig.15

Fig. 16